(19) **Europäisches Patentamt**

**European Patent Office**

**Office européen des brevets**

(11) **EP 0 571 019 B1**

(12) **EUROPEAN PATENT SPECIFICATION**

(45) Date of publication and mention
of the grant of the patent:
**26.01.2000 Bulletin 2000/04**

(51) Int. Cl.$^7$: **H03M 13/00**, G11B 20/18

(21) Application number: **93201356.8**

(22) Date of filing: **11.05.1993**

(54) **Extended error protected communication system**

Erweitertes fehlergeschütztes Kommunikationssystem

Système de communication à protection renforcée contre erreurs

(84) Designated Contracting States:
**DE ES FR GB IT**

(30) Priority: **19.05.1992 EP 92201421**

(43) Date of publication of application:
**24.11.1993 Bulletin 1993/47**

(73) Proprietor:
**Koninklijke Philips Electronics N.V.
5621 BA  Eindhoven (NL)**

(72) Inventor:
**Baggen, Constant Paul Marie Jozef
NL-5656 AA  Einhoven (NL)**

(74) Representative:
**Peters, Rudolf Johannes et al
INTERNATIONAAL OCTROOIBUREAU B.V.,
Prof. Holstlaan 6
5656 AA  Eindhoven (NL)**

(56) References cited:
**EP-A- 0 291 167          EP-A- 0 333 599
WO-A-88/09011          FR-A- 2 665 990**

- **PATENT ABSTRACTS OF JAPAN vol. 11, no. 152
(E-507), 16 May 1987 & JP-A-61 288524 (SANYO),
18 December 1986,**

**Description**

The invention relates to the field of communicating using an extended communication signal encoded according to a digital encoding standard and comprising data that is covered by an error protection block code. Various systems are known that use such extended communication signal, such as the standards of Compact Disc for hifi audio, and the extended version thereof, CD-ROM, that offers a still higher degree of error protection for sensitive data. At present, also television signals are being standardized according to a bit-based format. Such standard often evolves through extended contacts between various manufacturers, governments, public bodies, and others. Besides standards for such consumer communications, also for professional communications standards have come into being, de jure or de facto. Generally, the format has user bits and control bits, but this is not a prerequisite. The term -extended- indicates that the system allows for communicating more information than the minimum, thereby allowing additional physical, logical, or notional channel capability. Physical means additional data, such that the user would experience a higher throughput. Logical means that additional data is transferred that borrows its relevance from the main data, such as a time indication that could be made accessible to the user or be used for enabling easier random access when the data is stored in a memory. Notional means that the functionality of the additional data is transparent to the user, such as when it would allow the system an improved functionality. Various other possibilities exist.

The data content of the user bits is unpredictable, their prescribed minimum amount is given, and in consequence, their existence is taken for granted.

Often, the extension bits are used on a systems level, to signal at the receiver side certain general properties of the signal organization. Such properties, without any limitation in the following recitation, may relate to the coding format of the associated user information, additional user information that may be added to the main user information according to discretion, frame numbering or time indication, or information that is self-referencing to the control information proper. Now often, at the first instance of setting up a new standard for the communication signal, supra, various ones of the control bits are left undefined but kept in reserve for possible later definition. Also, the need has emerged for error protection of the control bits or other extension bits against burst and/or random errors. By itself, error protection block codes are well known. Now, for the protection of the extension bits, certain ones of which have been defined according to some standardization or assignation protocol, whereas others are not (yet) so defined, and in consequence, can from the level of the control be considered as dummy or spare bits, there are various different possibilities. A first possibility is to put all as yet undefined bits equal to zero and to have an error correction scheme cover both defined and undefined bits. However, the inventor has recognized that this amounts to throwing away transfer and error protection capability of the channel. Another aspect is to allow for a variable error correcting code (ECC) strategy to cope with known channel quality variations: the decoder should be allowed to decide which level of error protection to be applied.

Amongst other things, it is an object of the present invention to provide a unitary protection format for the actually defined control bits that offers an elevated protection level, while retaining space for later definable bits that would also have a particular error protection level which then would leave part of the error protection of the earlier defined bits operational.

According to one of its aspects, the invention provides a decoding method as recited in CLAIM 1. Upon later usage of redundancy bits associated with later terms of the sequence for other purposes, the error protection offered by earlier terms of the sequence remains operational. Although n may have arbitrary integer values, at least 2 is advantageous: this means that two successive levels of protection may be surrendered. The format is furthermore self-contained, thereby not needing external indication on the effectively present level of protection: such external indication could itself be subject to errors. According to the invention, the structure of a code block itself would indicate whether it has a higher, or, alternatively, lower degree of error protection. The code as defined supra is not a concatenated code: upon decoding a concatenated code each decoding level is fully evaluated before the next level decoding can be undertaken. In this next level, the redundancy related to the preceding level is completely left out of consideration. According to the present invention, the codes used by necessity belong to a single mathematical class and no information outside the code block need be accessed to indicate the applicable protection level.

By itself, Patent Abstracts of Japan, Vol. 11, No. 152 (E-507), 16 May 1987 & JP A-61 280 524, 18 December 1987 describe the using of a factorizable negerator polynomial in combination with efforts for decreasing the amount of ROM required for error correction. The reference does not describe the usage of a uniform-format error protected block, wherein certain bit positions may have their function selectable to either data or redundancy. In contradiction, the extra redundancy appears to be used if the lesser amount proves insufficient.

Advantageously, said data is control data that is ancillary to user data in said signal that is not covered by said code. Often, the amount of user data is large with respect to the amount of control data. The user data may be digital, such as teletext, or analog, such as a conventional television signal. The coding according to the invention may protect small or large quantities of data.

Advantageously, said code is a BCH-code. BCH-codes have a well established theory on their generation and on their decoding. The code may be binary, or based on multi-bit symbols, such as in Reed-Solomon codes. The choice could be made on the basis of a fault model. For random bit errors the binary codes are preferred.

Advantageously, the factors $g_0(x), \ldots g_n(x)$ are minimal polynomials, which have minimal degree for attaining a particular distance as given by the lowest degree of the polynomial that contains the intended power of $\alpha$. This also results in a minimum amount of redundancy. Sometimes, decoding may be easier for a non-minimal polynomial.

Advantageously, each generator polynomial $G_j(x)$, wherein $j \geq 2$ defines a number of equally spaced zeroes of $G_n(x)$. The zeroes may be consecutive zeroes, or their spacing could be uniform by two, three, or more positions. This leaves the index of the minimal polynomials open. Such uniform structure is easier to decode and better accessible to coding theory, and its effective protectivity easier to predict.

Advantageously, for minimal binary BCH-codes, the generator polynomial is

$$G_n(x) = m_1(x) * m_3(x) \ldots * m_{2n+1}(x)$$

and each polynomial $G_{2j+1}(x)$ allowing to correct an additional error over such error correction as realizable through $G_{2j-1}(x)$, provided that $m_{2j+1}(x)$ introduces an additional zero into the generator polynomial $G_{2j+1}(x)$. It has been found that it is advantageous that stepping up the level of protection should mean increasing the level of correctability. The first term may well relate to a CRC-code. These are well-known and easy to implement. It should be noted that in this particular generator polynomial, the zero covered by $m_9(x)$ is also covered by $m_3(x)$, so that the former would not increase the distance of the code. The same applies to even-numbered minimal polynomials.

Advantageously, the code is based upon a generator polynomial

$$G_n(x) = (x-1)^k * G_n(x)$$

wherein $k \leq n+1$, and each of said k factors (x-1) being co-encoded with an exclusive one of said factors, starting with the first (n=0). Combining factor $m_1(x)$ with a factor (x-1) increases the distance of these paired factors. The combination of further higher-numbered factors with the same factor (x-1) does not increase the distance per se, but still enhances the capacity for correcting burst errors in a binary code.

In particular, the signal may be a broadcast signal for digital television. A favourite line is first half No. 23 in the PALPLUS format for positioning the extended consumer communication signal in question. It should be noted that the standardization question as touched supra is especially in consumer systems a hot item: upgrading system capability should not instantaneously require new user terminals.

The invention also relates to a method of encoding an extended communication signal as defined earlier.

The invention also relates to a decoder for decoding such extended communication signal, in particular being arranged for generating either an O.K. signal upon completion of a correction operation, or an -unfeasible- signal under control of either an uncorrectable error for the decoder in question detected, or an error outside the correctable range of the code received. This set-up is advantageous in various aspects. The decoder correctly signals that it cannot handle the error pattern. The problem then may reside either in a code having too small a distance, or in a decoder that has insufficient capability. Of course both cases may occur simultaneously. The decoder need not know in advance the distance of a code received, and in fact, may receive intermixed codes that have non-uniform distances.

Various further advantageous aspects are recited in dependent Claims.

BRIEF DESCRIPTION OF THE FIGURES

The invention will be explained more in detail hereinafter with respect to a non-limitative embodiment which is described with respect to Figures and Tables that show, respectively:

Table 1 minimal polynomials;
Table 2 nested BCH-codes with primitive block length 127;
Table 3 probability of undetected error for bursts;
Table 4 estimation of minimum weight code words;
Table 5 probability of error for random errors;
Figure 1 configurations of various code words;
Figure 2 an overall block diagram of the system;
Figure 3 a flow chart of the decoding operations.

TREATISE ON THE CODING ASPECTS OF THE INVENTION

Various error protecting codes like CRC's (cyclic redundancy checks), Hamming codes and also many multiple error correcting codes can be described as BCH codes. Generally, however, the invention is applicable to such codes that have a factorizable polynomial. As always, the effective choice among the gamut of codes is made as based on arguments relating to fault model, size of the block, required level of error protection and ease of the decoding. Now, in the remainder, a code word (a string of bits) of length n is represented as a polynomial in the indeterminate quantity x, i.e.,

$$(c_0, c_1, ..., c_{n-1}) \Leftrightarrow c_0 + c_1 x + ... + c_{n-1} x^{n-1} = \sum_{i=0}^{n-1} c_i x^i := c(x),$$

where $c_i \, \varepsilon \, \{0,1\}$. Hence the power i of $x^i$ serves as a position indicator of bit $c_i$. Likewise a received word (possibly containing errors) is represented as r(x). The specific example discussed hereinafter relates to binary BCH-codes. However, the invention just as well applies to non-binary BCH-codes such as Reed-Solomon codes and even to non-BCH-codes.

BCH codes are cyclic codes and they are characterized by the fact that each code word c(x) is a multiple of a generator polynomial g(x). This fact is used for encoding and decoding BCH codes. For instance, in checking a CRC, the received word r(x) is fed through a feedback shift register, which in mathematical terms is equivalent to dividing (in the Galois Field GF(2)) the received word by the polynomial that is represented by the feedback connections of the feedback shift register. If the remainder is zero (CRC=OK), the received word is a multiple of g(x):

$$r(x) \bmod g(x) = 0,$$

i.e., the received word belongs to the code. If the remainder is not zero, an error is detected. Depending on the properties of the code, errors can be corrected by applying mathematical operations on this remainder. The error detecting and correcting properties are determined by the factors of the generator polynomial, i.e., in our case

$$g(x) = m_0(x)m_1(x)m_3(x)...,$$

where each factor $m_i(x)$ is itself a polynomial. The factors itself may be minimal and thus have the lowest amount of redundancy that is commensurate with the intended distance of the code. The factors may be irreducible or may itself be a product of irreducible polynomials. Now, a particular factor may be $m_0(x)=(x + 1)$, which corresponds to a single overall parity check if c(x) is divisible by (x + 1). Polynomial g(x) can have multiple factors, whereby the error correcting capability generally increases if more factors are included.

An exemplary CRC-8 is defined by:

$$g(x) = g_4(x) = (x + 1)m_1(x),$$

where $m_1(x)$ is a degree seven primitive polynomial over GF(2). Hence, the degree of $g_4(x)$ equals eight and is equal to the number of parity bits. BCH theory shows that the minimum distance d of this code $C_4$ equals four, provided that the code word length does not exceed 127. We indicate the distance of the generated code by the subscript of C and the subscript of its generator polynomial g. The code $C_4$ generated by $g_4(x)$ detects any error pattern of weight less than or equal to three. It may alternatively correct a single error and detect simultaneously all double errors.

If we add $m_3(x)$ of degree seven to $g_4(x)$, we get a code $C_6$ generated by

$$g_6(x) = m_3(x)g_4(x),$$

which is a subcode of the code generated by $g_4(x)$, i.e., the code words belonging to $C_6$ are a subset of the code words belonging to $C_4$. The error correcting capability increases to two bits error correction or five bits error detection, again provided that the code word length does not exceed 127. The addition of $m_3(x)$ to the generator polynomial means that seven more parities must be stored, i.e., $C_6$ has 15 parity bits. An alternative possibility is:

$$g'_6(x) = (x+1)m_3(x)g_4(x).$$

which needs 16 parity bits and has two coinciding zeroes at x=-1. Note that for a BCH-code defined over a filed of characteristic 2, the factors (x-1) and (x+1) are identical. Likewise, we can construct codes $C_8$ and $C_{10}$, generated by

$$g_8(x) = m_5(x)g_6(x) \tag{1}$$

$$g_{10}(x) = m_7(x)g_8(x), \tag{2}$$

having respectively 22 and 29 parity bits. The relationships between the nested codes are given by

$$C_4 \supset C_6 \supset C_8 \supset C_{10}$$

In general a code $C_d$, generated by $g_d(x)$, can correct t and detect simultaneously any number of e (e ≥ t) errors provided

$$t + e < d.$$

It should be noted that the balance between t and e in an actual situation is dependent on the required detection and miscorrection probabilities. Using the weight distribution of the codes involved, these can be calculated.

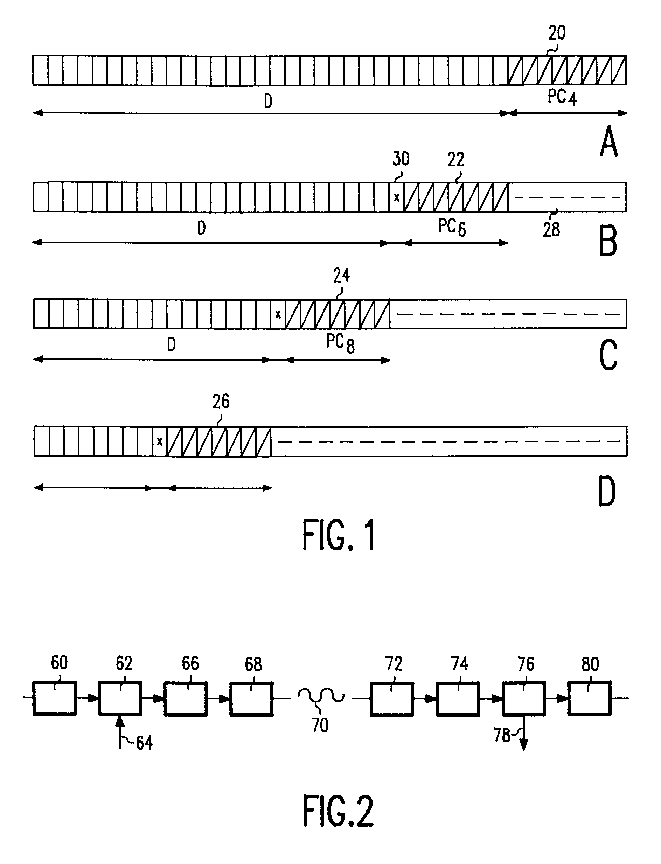

In this respect, Figure 1 shows the format of 40 bit code words, of which the first one is constituted according to $C_4$, up to the last one that is constituted according to $C_{10}$. Now, Figure 1A shows the 40 bit word consisting of 32 data bits D and 8 parity bits 20 of a CRC check code, the error protection capability thereof having been described earlier. The next Figure 1B shows the $C_6$ code, that has 7 additional parity bits 22 and 24 data bits D. Part 28 indicates the parity bits of the code $C_4$ and which in Figure 1B are also used to raise the level of error protection. A single bit 30 can be used for various objects. First, it can be data that is error protected at this level. Going to the next higher protection level may lead to a shift over 8 bits of the boundary between data and parity, which is easy for calculation. At this higher level, bit 30 would then be a dummy bit. Another solution is a shift of the boundary over seven bits, which keeps as much data available as possible, but complicates calculations in an 8-bit processor. A third solution is to add another factor (x+1) to the generator polynomial. This does not increase the distance of the code (double use of the same factor polynomial), but improves the error correction and detection capacity against burst errors. Figure 1C shows the format of a C8 code word that has the data at 16 bits, and an additional 7 bits parity. Figure 1D shows the format of a C10 code word. Using the three bits indicated by small crosses would increase the maximum available data to 11 bits at the most protected level, at the price of rather irregular processing requirements. Of course, the nesting organization according to the present invention may be done at other modularity steps, wherein the module preferably is a power of 2. Of course, the 40 bit code word format is only one of many possibilities.

DESCRIPTION OF THE HARDWARE

Figure 2 is an overall block diagram of the system. Block 60 provides the user data. For television, it may for example comprise the picture itself, various synchronization signals and additions, such as teletext. In block 62, various particular data may be added, such as control data, along input 64. It is feasible that either these particular data, or all data are protected according the teachings of the present invention. There may be various different levels of error protection according to the present invention at any one time. In block 66 the actual error protection is provided, such as by matrix multiplication or other technique. In block 68 any remaining operation for the transmission may be effected, such as conversion to channel bits and generally modulation with carrier frequencies and the like. After broadcast 70, block 72 recaptures the transmitted data through demodulation. Block 74 recognizes those fractions of the data that are error protected and effects error protection, as will be described hereinafter. In block 76, the control data is separated from the main stream according to arrow 78. In block 80, user data is rendered presentable to a user, such as by display, hard copy, or otherwise.

Both at the encoding side and at the decoding side, all operations may be mapped on common hardware. At the decoding side, this may be standard hardware that is suitably programmed, such as an 8-bit microcontroller. For volume manufacture, specially designed hardware may be used.

DESCRIPTION OF THE DECODING PROCESS

A particular advantage of this set of nested codes is, that a code $C_i$ can be decoded by the decoder of all codes $C_j$, j ≤ i, up to the distance of $C_j$. For example, if the actual code transmitted is generated by $g_6(x)$, we can still check the CRC-8, since a multiple of $g_6(x)$ certainly is a multiple of $g_4(x)$. The concept of nested codes allows a redefinition of bits and codes in a later stage without backward compatibility problems. We assume that initially when only a few information bits have been defined, for instance the code $C_{10}$ is being used. If somewhere in the future more information bits are needed and channel conditions turn out to be favourable, we can change the transmitted code from $C_{10}$ to $C_8$, thereby gaining seven or eight more information bits, of course with less error protection. In another later stage, we might change again from $C_8$ to $C_6$ and once more from $C_6$ to $C_4$, each time gaining another seven or eight information bits. With $C_4$, we have reached the CRC-8, and we cannot reduce the number of parities anymore without severely compromising the reliability. Hence the CRC-8 can be used for all codes.

The effective decoder chosen at the receiver side may be codetermined by cost considerations; in fact, often an independent selection is possible, which is given by way of example. For instance, one could opt for only checking the CRC-8, although code $C_{10}$ is transmitted. Or one could build a decoder that corrects at most a single error while $C_{10}$ is transmitted.

In table 1, we give a list of the required minimal polynomials for constructing the code. In table 2, we give a list of the nested codes, indicating for each code the number of parity symbols r, the distance d and the generator polynomial of the code. The generator polynomial is given by the powers of x that are present in g(x), i.e.

$$x^8 + x^7 + x^5 + x^4 + x + 1 \Leftrightarrow 8,7,5,4,1,0$$

Since the receiver does not know the actual distance of the code, we have to define a decoding strategy. The decoding strategy results in about the same acceptable probabilities for undetected error as while using the CRC-8, but with greatly improved probabilities for correct reception in case the actually transmitted code has a higher distance.

We present a possible decoding strategy in the form of a pseudo language. We presume that the generator polynomial g(x) is a product of minimal polynomials $m_0(x)$, $m_1(x)$ and an unknown number of other irreducible factors so that in each successive nested layer the designed distance increases by 2. Upon reception, we define the syndromes according to:

$$S_j = r(x) \bmod m_j(x),$$

i.e., $S_j$ is the remainder of dividing the received word r(x) by $m_j(x)$. Given a number of syndromes $S_j$, we can calculate the corresponding error pattern using the BCH decoding algorithm. The outcome of this algorithm is either an estimated error pattern with a corresponding Hamming weight t (which can be zero if there were no errors at all), or an uncorrectable error pattern (algorithm fails). The decoding strategy can be seen as a tree with nodes and leaves. The nodes are labelled by the distance d that is considered by the decoder at that point.

```
Begin (node 4)

calculate S_0

calculate S_1

estimate error pattern (test if S_0 and S_1 are zero)

if t=0

    then OK, exit

    else (node 6)

        calculate S_3

        estimate error pattern (try single error correction)

        if t=1

            then correct, OK, exit

            else (node 8)

            calculate S_5

            estimate error pattern (try double error correction)

            if t=2

                then correct, OK, exit

                else (node 10)

                    calculate S_7

                    estimate error pattern (try triple error correction)

                    if t=3

                        then correct, OK, exit

                        else ERROR, exit

        end
```

The exit attained after ERROR signalization means that either the number of errors was greater than correctable with this particular decoder implementation, or, alternatively, was greater than correctable with the actually implemented code. In the latter case, the decoder might or might not have been able to tackle the actually encountered error pattern.

Note that a decoder implementation need not search the whole tree. After each "else" the decoder can quit with the outcome ERROR if the required operations in the next node are not implemented. For instance for a simple CRC-8 checker, the item - (node 6)- is changed into -ERROR, exit-, whereas the lines from -calculate $S_3$-(up through the penultimate line, are deleted. For a single-error corrector, in the above - (node 8)- is changed into -ERROR, exit-, whereas all lines from -calculate $S_5$-up through the penultimate line, are deleted.

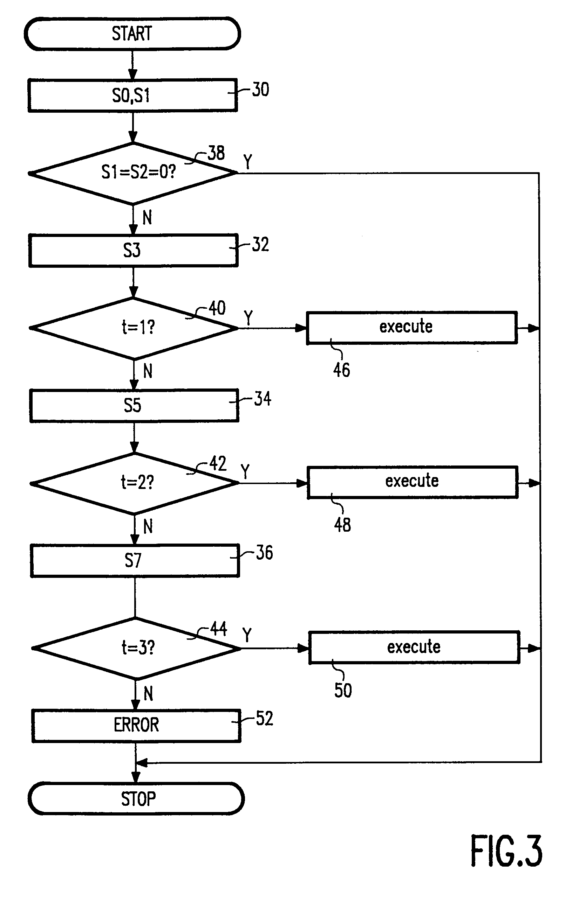

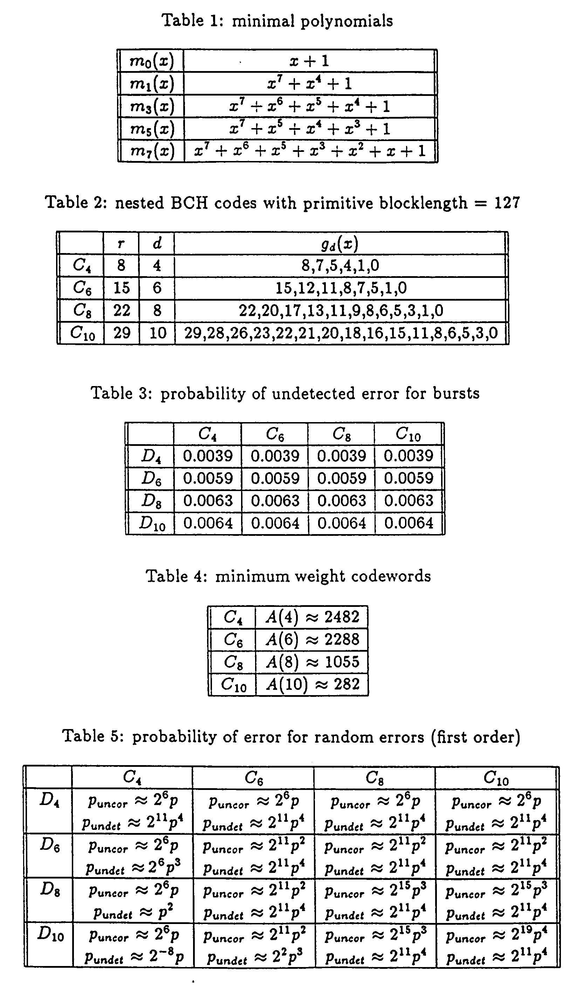

Figure 3 gives the above procedure in a flow chart. Blocks 30, 32, 34, 36 calculate the syndromes as necessitated, blocks 38, 40, 42, 44 test for actual presence of respective predetermined numbers of errors (0, 1, 2, 3, respectively), blocks 46, 48, 50 execute the correction proper, and block 52 signals an effective error.

Various other strategies may be adopted, as dependent on the factorization, estimated error probabilities, available hardware, and others. The step in distance provided by the additional factors may be different. In principle, a distance increase of one would be feasible, but at least two is preferred. This increase need not be uniform over the sequence of factors. One or two levels could be executed on-line, whereas higher protection could need recourse to a background processor.

PERFORMANCE EVALUATION

Hereinafter, the performance will evaluated for each of the above combinations of a code $C_4...C_{10}$ and a decoder $D_4...D_{10}$, using the method described with respect to Figure 2, and looking to both random errors and burst errors:

$D_4 := t = 0$ using $S_0$ and $S_1$
$D_6 :=$ up to t=1 using $S_0$, $S_1$ and $S_3$
$D_8 :=$ up to t=2 using $S_0$, $S_1$, $S_3$ and $S_5$
$D_{10}:=$ up to t=3 using $S_0$, $S_1$, $S_3$, $S_5$ and $S_7$

The performance is expressed as an uncorrected error rate $p_{uncor}$ (probability that a decoder cannot correct the received word) and an undetected error rate $P_{undet}$ (probability that the decoder wrongly corrects or does not detect an error pattern). The decoding strategy can be considered as a tree, where each node that is visited by decoder $D_i$ has a separate contribution to the resulting $p_{uncor}$ and $p_{undet}$ of that particular decoder, depending on the probability of the decoder reaching that node and the conditional probabilities (conditioned on the decoder reaching that node) of the decisions taken at that node.

For burst errors, we assume that the size of the burst is such that the syndrome can be considered as being random. The desired response of all decoders in all instances should be a detection of an uncorrectable error pattern. All other outcomes, in which a decoder (wrongly) accepts or corrects the received word, are defined an undetected error. Table 3 indicates the probability of such undetected errors for each possible code and decoder pair, given that a large burst has occurred, i.e., we present probabilities conditioned on the occurrence of a burst. The probability for undetected error of a sufficiently large burst does only depend on the decoding strategy and not on the code, since the received pattern is considered to be random. For a node, assuming r parity bits and estimating an error pattern of weight t, the contribution is given by

$$\Delta p_{undet} \approx 2^{-r} \binom{n}{t}$$

i.e., the fraction of randomly chosen syndromes that correspond to a correctable error pattern given the first r syndrome bits. Table 3 is constructed using n=64. Note that for a first order approximation

$$p_{undet}(D_{10}) = \Delta p_{undet}(node\,4) + \Delta p_{undet}(node\,6) + \Delta p_{undet}(node\,8) + \Delta p_{undet}(node\,10).$$

Likewise, the other entries can be calculated.

Table 5 indicates for each possible code and decoder pair the first order approximation to the uncorrected and undetected error probability, assuming random bit errors with (small) bit error probability p. In order to evaluate the performance, we must distinguish between a number of node situations.

The first node situation is where the code $C_d$ and the current decoding attempt are matched with respect to the distance d, i.e., the transmitted code has r parity bits and the decoder considers also r parity bits. This corresponds to the traditional way of evaluating the performance of a code. For a linear code $C_d$ having length n, minimum distance d and a number A(d) words of weight d, the probability of an uncorrected error assuming t error correction is (first order estimation)

$$\Delta p_{uncor} \approx \binom{n}{t+1} p^{t+1}, \ p << 1.$$

Furthermore, the probability of an undetected error can be approximated by

$$\Delta p_{undet} \approx A(d) \binom{d}{t} p^{d-t}$$

We assume that the weights are binomially distributed for weights larger than or equal to d, i.e.,

$$A(d) \approx 2^{-r} \binom{n}{d},$$

where r is the number of parity bits of the code. Note that since x+1 is a factor of g(x) for all codes, A(w)=0 for odd w. Assuming n=64, we obtain the a list of minimum weight code words as given in table 4.

The second node situation is, where the distance of the actual transmitted code is larger than the distance considered by the decoder at that node, i.e., $C_d$ being transmitted has r parity bits, while at the current node r' < r bits are considered. In that case, the decoder is unaware of the extra constraints on the code, and it considers only the zeroes of g(x) that correspond to the first r' parity bits. Hence the performance on error correction and error detection is the same as if $C_d$, corresponding to r' parity bits would have been transmitted. Note that in case of an uncorrectable error pattern at a particular node, the next node will be visited with probability 1 - $\Delta p_{undet}$, if that node has been implemented in the decoder. If not, an error is detected.

In the third node situation, a decoder attempts to decode $C_d$ beyond its designed distance. The only correct outcome of decoding attempts in such a situation should be a decoding failure, since a correctable error pattern should have been corrected in one of the foregoing nodes. The uncorrectable error rate is determined by $C_d$, since up to distance d, consistent results can be obtained by considering the zeroes of the generator polynomial. However, if the decoder evaluates the received word in a nonexisting zero of the code, the result will be a random seven bit pattern (with a probability of $2^{-7}$ that it is consistent with a given error pattern), if we assume that all code words are equally likely.

This result can easily be shown by counting arguments. Consider for instance the standard array of $C_6$ which has $2^{15}$ cosets. Each coset corresponds to a particular syndrome. The syndrome (15 bits) may be partitioned in $S_0$ (1 bit), $S_1$ (7 bit) and $S_3$ (7 bit). Since any fifteen bit pattern occurs exactly once, there is exactly one coset for each value of $S_3$ and $S_0 = S_1 = 0$. Since the code $C_4$ consists of the union of the cosets having $S_0 = S_1 = 0$, the code $C_4$ is partitioned in sets of equal size with respect to the value of $S_3$. Since we assume that each codeword has the same likelihood of being transmitted and because the calculation of a remainder is a linear operation, the uniform outcome of the remainder in a nonexisting zero has been shown.

Decoding attempts beyond the designed distance add nothing to the correcting capabilities ($p_{uncor}$), but do have a detrimental effect on $p_{undet}$, since a detected error might seem correctable after all. The contribution to $p_{undet}$ at node d+2 equals to a first order approximation

$$\Delta p_{undet} \approx 2^{-7} [A(d)\binom{d}{t} p^{d-t}],$$

where t is the number of errors that the decoder tries to correct at node d+2. Likewise, the contribution to $p_{undet}$ at node d + 4 in first order approximation is

$$\Delta p_{undet} \approx 2^{-14} [A(d) \binom{d}{t} p^{d-t}],$$

where t is the number of errors that the decoder tries to correct at node d+2.

## Claims

1. A method of decoding an error protected block of extended data to produce a user block of user data, the protected block having been produced by (a) encoding an original user block of user data by a linear and systematic primary error protected block code defined by a factorizable generator polynomial
$G_n(x) = g_0(x) \ldots g_{n-1}(x)^* g_n(x) = G_{n-1}(x)^* g_n(x)$ if the original user block had a first length or (b) encoding the original user block by a linear and systematic secondary error protected block code defined by a generator polynomial $G_{n-1}(x) = g_0(x) \ldots g_{n-1}(x)$ if the user block has a second length which was greater than the first length, the error protected block being the same length whether the original user block which was encoded to produce it has the first length or the second length, the method comprising:

    decoding the error protected block in accordance with the secondary code to produce a first decoded block;
    detecting whether the first decoded block contains correct user data, and if it does, outputting (46) the first decoded block as the user block; and

decoding the error protected block in accordance with the primary code to produce a second decode block if the first decode block does not contain correct user data, and thereafter, outputting (48, 50) the second decoded block as the user block.

2. The decoding method as claimed in claim 1, wherein the primary and secondary code are BCH codes.

3. A decoder (74) for decoding an error protected block of extended data to produce a user block of user data, the error protected block having been produced by (a) encoding an original user block of user data by a linear and systematic primary error protected block code defined by a factorizable generator polynominal

$$G_n(x) = g_0(x) \ldots g_{n-1}(x)^* g_n(x) = G_{n-1}(x)^* g_n(x)$$

if the original user block had a first length, or (b) encoding the original user block by a linear and systematic secondary error protected block code defined by a generator polynominal $G_{n-1}(x) = g_0(x) \ldots g_{n-1}(x)$

if the original user block had a second length which was greater than the first length, the error protected block being the same length whether the original user block which was encoded to produce it had the first length or the second length, the decoder comprising:

first decoding means for decoding the error protected block in accordance with the secondary code to produce a first decoded block;

detection means for detecting whether the first decoded block contains correct user data:

second decoding means for decoding the error protected block in accordance with the primary code to produce a second decoded block if the first decoded block does not contain correct user data: and

means for outputting the first decoded block as the user block if it contains correct user data, or the second decoded block as the user block if the first decoded block does not contain correct user data.

4. The decoder as claimed in claim 3, further comprising means for activating said first decoding means and said detection means in sequence and, if necessary, said second decoding means thereafter.

5. The decoder as claimed in claim 3 or 4, wherein said first decoding means is adapted to correct a first amount of errors and to detect a second amount of errors which is greater than the first amount of errors.

6. The decoder as claimed in claim 3, 4 or 5, wherein said first and second decoding means utilize common hardware.

7. The decoder as claimed in any of the claims 3-6, wherein the primary and secondary codes are BCH codes.

8. A transmitter-receiver communication system, comprising: an encoder, including

receiving means for receiving a user block of user data having either a first length or a second length, where the second length is greater than the first length;

encoding means for encoding the user block by a linear and systematic primary error protected block code defined by a factorizable generator polynominal

$$G_n(x) = g_0(x) \ldots g_{n-1}(x)^* g_n(x)$$

to produce the error protected block

wherein the error protected block produced by said encoding means has a standard length, that is independent of the value of n; and a decoder including receiving means for receiving said standard length error protected block;

first decoding means for decoding the error protected block in accordance with a code having a relatively lower value of n to produce a first decoded block;

first detection means for detecting whether the first decoded block contains correct user data;

second decoding means for decoding the error protected block in accordance with a code having a relatively higher value of n to produce a second decoded block if the first decoded block does not contain correct user data; and

means for outputting the first decoded block if it contains correct user data or the second decoded block if the first decoded block does not contain correct user data.

9. The system as claimed in claim 8, wherein the primary and secondary codes are BCH codes.

**Patentansprüche**

1. Verfahren zur Decodierung einer fehlergeschützten Blocks erweiterter Daten zum Erzeugen eines Benutzerblocks mit Benutzerdaten, wobei der geschützte Block erzeugt wurde durch (a) Codierung eines ursprünglichen Benutzerblocks mit Benutzerdaten durch einen linearen und systematischen, ersten, fehlergeschützten Blockcode, definiert durch ein in Faktoren zerlegbares erzeugendes Polynom $G_n(x)=g_0(x) ... g_{n-1}(x)*g_n(x)=G_{n-1}(x)*g_n(x)$, wenn der ursprüngliche Benutzerblock eine erste Länge hat, oder (b) Codierung des ursprünglichen Benutzerblocks durch einen linearen und systematischen, zweiten, fehlergeschützten Blockcode, definiert durch ein erzeugendes Polynom $G_{n-1}(x)=g_0(x) ... g_{n-1}(x)$, wenn der Benutzerblock eine zweite Länge hat, die größer als die erste Länge ist, wobei der fehlergeschützte Block dieselbe Länge aufweist, unabhängig davon, ob der ursprüngliche zu seiner Erzeugung codierte Benutzerblock die erste oder zweite Länge hat, wobei das Verfahren folgendes beinhaltet.

   Decodierung des fehlergeschützten Block gemäß dem zweiten Code zum Erzeugen eines ersten decodierten Blocks;
   Erkennung, ob der erste decodierte Block richtige Benutzerdaten enthält, und in diesem Fall Ausgabe (46) des ersten decodierten Blocks als Benutzerblock; und
   Decodierung des fehlergeschützten Blocks gemäß dem ersten Code zum Erzeugen eines zweiten decodierten Blocks, falls der erste decodierte Block keine richtigen Benutzerdaten enthält, und anschließend Ausgabe (48, 50) des zweiten decodierten Blocks als Benutzerblock.

2. Decodierverfahren nach Anspruch 1, wobei der erste und der zweite Code BCH-Codes sind.

3. Decoder (74) zur Decodierung eines fehlergeschützten Blocks erweiterter Daten zum Erzeugen eines Benutzerblocks mit Benutzerdaten, wobei der geschützte Block erzeugt wurde durch (a) Codierung eines ursprünglichen Benutzerblocks mit Benutzerdaten durch einen linearen und systematischen, ersten, fehlergeschützten Blockcode, definiert durch ein in Faktoren zerlegbares erzeugendes Polynom $G_n(x)=g_0(x) ... g_{n-1}(x)*g_n(x)=G_{n-1}(x)*g_n(x)$, wenn der ursprüngliche Benutzerblock eine erste Länge hat, oder (b) Codierung des ursprünglichen Benutzerblocks durch einen linearen und systematischen, zweiten, fehlergeschützten Blockcode, definiert durch ein erzeugendes Polynom $G_{n-1}(x)=g_0(x) ... g_{n-1}(x)$, wenn der ursprüngliche Benutzerblock eine zweite Länge hat, die größer als die erste Länge ist, wobei der fehlergeschützte Block dieselbe Länge aufweist, unabhängig davon, ob der ursprüngliche zu seiner Erzeugung codierte Benutzerblock die erste oder zweite Länge hat, wobei der Decoder folgendes beinhaltet:

   erste Decodiermittel zum Decodieren des fehlergeschützten Block gemäß dem zweiten Code zum Erzeugen eines ersten decodierten Blocks;
   Erkennungsmittel zum Erkennen, ob der erste decodierte Block richtige Benutzerdaten enthält;
   zweite Decodiermittel zum Decodieren des fehlergeschützten Blocks gemäß dem ersten Code zum Erzeugen eines zweiten decodierten Blocks, falls der erste decodierte Block keine richtigen Benutzerdaten enthält; und
   Mittel zum Ausgeben des ersten decodierten Blocks als Benutzerblock, falls er richtige Benutzerdaten enthält, oder des zweiten decodierten Blocks als Benutzerblock, falls der erste decodierte Block keine richtigen Benutzerdaten enthält.

4. Decoder nach Anspruch 3, der des Weiteren Mittel zum Aktivieren der Reihe nach der genannten ersten Decodiermittel und der genannten Erkennungsmittel und, falls erforderlich, danach der genannten zweiten Decodiermittel, enthält.

5. Decoder nach Anspruch 3 oder 4, wobei die genannten ersten Decodiermittel so ausgelegt sind, dass sie eine erste Fehlermenge korrigieren und eine zweite Fehlermenge erkennen, die größer als die erste Fehlermenge ist.

6. Decoder nach Anspruch 3, 4 oder 5, wobei die genannten ersten und zweiten Decodiermittel herkömmliche Hardware nutzen.

7. Decoder nach einem der Ansprüche 3 bis 6, wobei der erste und der zweite Code BCH-Codes sind.

8. Sender-Empfänger-Kommunikationssystem, das folgendes beinhaltet: einen Codierer, der folgendes umfasst:

Empfangsmittel zum Empfangen eines Benutzerblocks mit Benutzerdaten, der entweder eine erste oder eine zweite Länge hat, wobei die zweite Länge größer als die erste ist;

Codiermittel zum Codieren des Benutzerblocks durch einen linearen und systematischen, ersten, fehlergeschützten Blockcode, definiert durch ein in Faktoren zerlegbares erzeugendes Polynom $G_n(x)=g_0(x) \ldots g_{n-1}(x)^*g_n(x)$ zum Erzeugen des fehlergeschützten Blocks, wobei der durch die genannten Codiermittel erzeugte fehlergeschützte Block eine Standardlänge aufweist, die unabhängig von dem Wert von n ist; und einen Decoder, der folgendes beinhaltet:

Empfangsmittel zum Empfangen des genannten fehlergeschützten Blocks mit Standardlänge;

erste Decodiermittel zum Decodieren des fehlergeschützten Block gemäß einem Code mit einem relativ geringeren Wert von n zum Erzeugen eines ersten decodierten Blocks;

erste Erkennungsmittel zum Erkennen, ob der erste decodierte Block richtige Benutzerdaten enthält;

zweite Decodiermittel zum Decodieren des fehlergeschützten Blocks gemäß einem Code mit einem relativ höheren Wert von n zum Erzeugen eines zweiten decodierten Blocks, wenn der erste decodierte Block keine richtigen Benutzerdaten enthält; und

Mittel zum Ausgeben des ersten decodierten Blocks, wenn er richtige Benutzerdaten enthält, oder des zweiten decodierten Blocks, wenn der erste decodierte Block keine richtigen Benutzerdaten enthält.

9.  System nach Anspruch 8, wobei der erste und der zweite Code BCH-Codes sind.

**Revendications**

1.  Procédé pour décoder un bloc protégé contre les erreurs de données étendues pour produire un bloc d'utilisateur de données d'utilisateur, le bloc protégé ayant été produit (a) par le codage d'un bloc d'utilisateur original de données d'utilisateur suivant un code en blocs à protection contre les erreurs linéaire et systématique primaire défini par un polynôme de générateur pouvant être factorisé $G_n(x)=g_0(x) \ldots g_{n-1}(x)^*g_n(x)=G_{n-1}(x)^*g_n(x)$ si le bloc d'utilisateur original présentait une première longueur, ou (b) par le codage du bloc d'utilisateur original par un code en blocs à protection contre les erreurs linéaire et systématique secondaire défini par un polynôme de générateur $G_{n-1}(x)=g_0(x) \ldots g_{n-1}(x)$ si le bloc d'utilisateur présente une deuxième longueur qui était supérieure à la première longueur, le bloc protégé contre les erreurs présentant la même longueur peu importe que le bloc d'utilisateur original qui a été codé pour le produire présente la première longueur ou la deuxième longueur, le procédé comprenant les étapes de:

    décoder le bloc protégé contre les erreurs conformément au code secondaire pour produire un premier bloc décodé;
    détecter si le premier bloc décodé contient des données d'utilisateur correctes, et si c'est le cas, produire (46) le premier bloc décodé comme le bloc d'utilisateur, et
    décoder le bloc protégé contre les erreurs conformément au code primaire pour produire un deuxième bloc décodé si le premier bloc décodé ne contient pas de données d'utilisateur correctes, et ensuite produire (48, 50) le deuxième bloc décodé comme le bloc d'utilisateur.

2.  Procédé de décodage suivant la revendication 1, dans lequel les codes primaire et secondaire sont des codes BCH.

3.  Décodeur (74) pour décoder un bloc protégé contre les erreurs de données étendues pour produire un bloc d'utilisateur de données d'utilisateur, le bloc protégé contre les erreurs ayant été produit (a) par le codage d'un bloc d'utilisateur original de données d'utilisateur suivant un code en blocs à protection contre les erreurs linéaire et systématique primaire défini par un polynôme de générateur pouvant être factorisé $G_n(x)=g_0(x) \ldots g_{n-1}(x)^*g_n(x)=G_{n-1}(x)^*g_n(x)$ si le bloc d'utilisateur original présentait une première longueur, ou (b) par le codage du bloc d'utilisateur original par un code en blocs à protection contre les erreurs linéaire et systématique secondaire défini par un polynôme de générateur $G_{n-1}(x)=g_0(x) \ldots g_{n-1}(x)$ si le bloc d'utilisateur présente une deuxième longueur qui était supérieure à la première longueur, le bloc protégé contre les erreurs présentant la même longueur peu importe que le bloc d'utilisateur original qui a été codé pour le produire présente la première longueur ou la deuxième longueur, le décodeur comprenant:

    des premiers moyens de décodage pour décoder le bloc protégé contre les erreurs conformément au code secondaire pour produire un premier bloc décodé;
    des moyens de détection pour détecter si le premier bloc décodé contient des données d'utilisateur correctes;

des deuxièmes moyens de décodage pour décoder le bloc protégé contre les erreurs conformément au code primaire pour produire un deuxième bloc décodé si le premier bloc décodé ne contient pas de données d'utilisateur correctes, et

des moyens pour produire le premier bloc décodé comme le bloc d'utilisateur s'il contient des données d'utilisateur correctes, ou le deuxième bloc décodé comme le bloc d' utilisateur si le premier bloc décodé ne contient pas de données d'utilisateur correctes.

4. Décodeur suivant la revendication 3, comprenant en outre des moyens pour activer lesdits premiers moyens de décodage et lesdits moyens de détection en ordre successif et, si nécessaire, lesdits deuxièmes moyens de décodage ensuite.

5. Décodeur suivant l'une quelconque des revendications 3 ou 4, dans lequel lesdits premiers moyens de décodage sont adaptés pour corriger un premier volume d'erreurs et pour détecter un deuxième volume d'erreurs qui est supérieur au premier volume d'erreurs.

6. Décodeur suivant l'une quelconque des revendications 3, 4 ou 5, dans lequel lesdits premier et deuxième moyens de décodage utilisent un matériel commun.

7. Décodeur suivant l'une quelconque des revendications 3 à 6, dans lequel les codes primaire et secondaire sont des codes BCH.

8. Système de communication émetteur-récepteur, comprenant:

un codeur, incluant
des moyens de réception pour recevoir un bloc d'utilisateur de données d'utilisateur présentant soit une première longueur, soit une deuxième longueur, la deuxième longueur étant supérieure à la première longueur;
des moyens de codage pour coder le bloc d'utilisateur suivant un code en blocs à protection contre les erreurs linéaire et systématique primaire défini par un polynôme de générateur pouvant être factorisé $G_n(x) = g_0(x) \ldots g_{n-1}(x) + g_n(x)$
pour produire le bloc protégé contre les erreurs;
dans lequel le bloc protégé contre les erreurs produit par lesdits moyens de codage présente une longueur standard qui est indépendante de la valeur de n; et
un décodeur incluant des moyens de réception pour recevoir ledit bloc protégé contre les erreurs de longueur standard;
des premiers moyens de décodage pour décoder le bloc protégé contre les erreurs conformément à un code possédant une valeur relativement inférieure de n pour produire un premier bloc décodé;
des premiers moyens de détection pour détecter si le premier bloc décodé contient des données d'utilisateur correctes;
des deuxièmes moyens de décodage pour décoder le bloc protégé contre les erreurs conformément à un code possédant une valeur relativement supérieure de n pour produire un deuxième bloc décodé si le premier bloc décodé ne contient pas de données d'utilisateur correctes, et
des moyens pour produire le premier bloc décodé s'il contient des données d'utilisateur correctes ou le deuxième bloc décodé si le premier bloc décodé ne contient pas de données d'utilisateur correctes.

9. Système suivant la revendication 8, dans lequel les codes primaire et secondaire sont des codes BCH.

FIG. 1

FIG.2

FIG.3

Table 1: minimal polynomials

| $m_0(x)$ | $x + 1$ |
|---|---|
| $m_1(x)$ | $x^7 + x^4 + 1$ |
| $m_3(x)$ | $x^7 + x^6 + x^5 + x^4 + 1$ |
| $m_5(x)$ | $x^7 + x^5 + x^4 + x^3 + 1$ |
| $m_7(x)$ | $x^7 + x^6 + x^5 + x^3 + x^2 + x + 1$ |

Table 2: nested BCH codes with primitive blocklength = 127

| | $r$ | $d$ | $g_d(x)$ |
|---|---|---|---|
| $C_4$ | 8 | 4 | 8,7,5,4,1,0 |
| $C_6$ | 15 | 6 | 15,12,11,8,7,5,1,0 |
| $C_8$ | 22 | 8 | 22,20,17,13,11,9,8,6,5,3,1,0 |
| $C_{10}$ | 29 | 10 | 29,28,26,23,22,21,20,18,16,15,11,8,6,5,3,0 |

Table 3: probability of undetected error for bursts

| | $C_4$ | $C_6$ | $C_8$ | $C_{10}$ |
|---|---|---|---|---|
| $D_4$ | 0.0039 | 0.0039 | 0.0039 | 0.0039 |
| $D_6$ | 0.0059 | 0.0059 | 0.0059 | 0.0059 |
| $D_8$ | 0.0063 | 0.0063 | 0.0063 | 0.0063 |
| $D_{10}$ | 0.0064 | 0.0064 | 0.0064 | 0.0064 |

Table 4: minimum weight codewords

| $C_4$ | $A(4) \approx 2482$ |
|---|---|
| $C_6$ | $A(6) \approx 2288$ |
| $C_8$ | $A(8) \approx 1055$ |
| $C_{10}$ | $A(10) \approx 282$ |

Table 5: probability of error for random errors (first order)

| | $C_4$ | $C_6$ | $C_8$ | $C_{10}$ |
|---|---|---|---|---|
| $D_4$ | $p_{uncor} \approx 2^6 p$ <br> $p_{undet} \approx 2^{11} p^4$ | $p_{uncor} \approx 2^6 p$ <br> $p_{undet} \approx 2^{11} p^4$ | $p_{uncor} \approx 2^6 p$ <br> $p_{undet} \approx 2^{11} p^4$ | $p_{uncor} \approx 2^6 p$ <br> $p_{undet} \approx 2^{11} p^4$ |
| $D_6$ | $p_{uncor} \approx 2^6 p$ <br> $p_{undet} \approx 2^6 p^3$ | $p_{uncor} \approx 2^{11} p^2$ <br> $p_{undet} \approx 2^{11} p^4$ | $p_{uncor} \approx 2^{11} p^2$ <br> $p_{undet} \approx 2^{11} p^4$ | $p_{uncor} \approx 2^{11} p^2$ <br> $p_{undet} \approx 2^{11} p^4$ |
| $D_8$ | $p_{uncor} \approx 2^6 p$ <br> $p_{undet} \approx p^2$ | $p_{uncor} \approx 2^{11} p^2$ <br> $p_{undet} \approx 2^{11} p^4$ | $p_{uncor} \approx 2^{15} p^3$ <br> $p_{undet} \approx 2^{11} p^4$ | $p_{uncor} \approx 2^{15} p^3$ <br> $p_{undet} \approx 2^{11} p^4$ |
| $D_{10}$ | $p_{uncor} \approx 2^6 p$ <br> $p_{undet} \approx 2^{-8} p$ | $p_{uncor} \approx 2^{11} p^2$ <br> $p_{undet} \approx 2^2 p^3$ | $p_{uncor} \approx 2^{15} p^3$ <br> $p_{undet} \approx 2^{11} p^4$ | $p_{uncor} \approx 2^{19} p^4$ <br> $p_{undet} \approx 2^{11} p^4$ |